# EUROPEAN PATENT APPLICATION

(11) **EP 2 658 060 A1**
(43) Date of publication of application: **30.10.2013**
(21) Application number: 13164462.7
(22) Date of filing: 19.04.2013
(51) Int. Cl.: H02H 1/00, G01D 5/26, G01R 31/12

(54) **Digital protection relay**

(30) Priority: 24.04.2012 KR 20120042829
(71) Applicant: LSIS Co., Ltd., Dongan-gu, Anyang-si Gyeonggi-do 431-848 (KR)
(72) Inventor: Jung, Jong Jin, Chungcheongbuk-do (KR)
(74) Representative: Johansson, Magnus

(57) **Abstract**

A digital protection relay is provided. An amplification factor is differently applied such that loss of a quantity of light with respect to an input signal is compensated for according to a length of an optical fiber cable for a point sensor. Thus, an occurrence of an arc can be more accurately detected, whereby power facilities and humans can be optimally protected from an arc accident.

## Description

### BACKGROUND OF THE INVENTION

### 1. Field of the Invention

The present disclosure relates to a digital protection relay and, more particularly, to a digital protection relay implemented to selectively apply an amplification factor (or an amplification rate) according to an optical signal for detecting an occurrence of an arc.

### 2. Background of the Invention

Various power facilities (or power utilities) are intricately associated in an electric power system, so when a portion of a electric power system is broken down (or fails), a failed portion is required to be quickly separated from the system, and here, a digital protection relay serves to do it.

In general, an occurrence of an accident due to an arc resulting from a short-circuit or degraded insulation within a distribution board may affect power instruments and power devices within the distribution board due to high temperature and high pressure, and cause power failure which may require a long period of time for its recovery. Namely, an accident due to an electrical arc causes various problems.

An arc protection function configuration may be divided into a method for receiving light through a point sensor and a method for receiving light through a loop sensor. Here, a point sensor may be used for the purpose of monitoring a particular point of a distribution board, which receives light at an end portion of an optical cable. In the case of a loop sensor, an optical cable is installed extendedly within a distribution board, and a loop sensor converts an optical signal input through the side of the optical cable into an electrical signal, whereby the loop sensor receives a signal signals through the entirety of the optical fiber.

The loop sensor has characteristics that an attenuation rate of optical fiber is low and a light detection range is as low as ±10 degrees. Meanwhile, in the case of an optical cable used for a point sensor, since a light is received at an end of the optical cable as mentioned above, a light detection range thereof should be ±90 degrees or greater, having a disadvantage in that an attenuation rate of optical fiber that satisfies such characteristics is increased.

Thus, as a length of an optical cable for a point sensor is increased, an attenuation rate thereof is also increased, resulting in an occurrence of malfunction of the arc protection relay.

### SUMMARY OF THE INVENTION

Therefore, an aspect of the detailed description is to provide a digital protection relay in which a different attenuation rate is applied according to a length of an optical cable for a point sensor when the optical cable is used.

To achieve these and other advantages and in accordance with the purpose of this specification, as embodied and broadly described herein, a digital protection relay includes: an optical fiber cable, for a point sensor, configured to transmit an optical signal for sensing an arc; a signal conversion unit configured to convert the optical signal into an electrical signal, and output the converted electrical signal; an amplifying unit configured to selectively apply an amplification factor to the electrical signal on the basis of a control signal, and output the same; and a microcomputer configured to output the control signal for determining the amplification factor according to a length of the optical fiber cable, and determine whether to drive the digital protection relay according to results obtained by comparing the amplified electrical signal with a predetermined reference value.

In an embodiment, the amplifying unit may include a plurality of operational amplifiers and selectively drive the operational amplifiers to have an amplification factor proportional to a length of the optical fiber cable according to the control signal received from the microcomputer.

In an embodiment, the microcomputer may include an amplification factor determining unit configured to compare the amplification factor proportional to a length of the optical fiber cable with an amplification factor with respect to a predetermined reference length to determine the amplification factor; and a comparing and determining unit configured to compare a magnitude of the electrical signal output from the amplifying unit with a predetermined reference value to determine whether an arc has occurred.

In an embodiment, the digital protection relay may further include: an output unit configured to display value '1' when the magnitude of the electrical signal is equal to or greater than the reference value according to the comparison results from the comparing and determining unit, and display value '0' when the magnitude of the electrical signal is smaller than the reference value.

In an embodiment, when a value displayed on the output unit is 1, the microcomputer may determine that an arc has occurred, and output a trip signal.

To achieve these and other advantages and in accordance with the purpose of this specification, as embodied and broadly described herein, a digital protection relay includes: an optical fiber cable, for a point sensor, configured to transmit an optical signal for sensing an arc; a signal conversion unit configured to convert the optical signal into an electrical signal, and output the converted electrical signal; an amplifying unit including a plurality of operational amplifiers and configured to selectively drive the operational amplifiers to output the electrical signal having a corresponding amplification factor; and a microcomputer configured to sense a length of the optical fiber cable on the basis of a transfer rate of the optical signal, determine an amplification factor in proportion to the length of the optical fiber cable, and output the control signal.

In an embodiment, the amplifying unit may include: one or more switching units configured to selectively drive the plurality of operational amplifiers.

In an embodiment, the microcomputer may compare the amplified electrical signal with a predetermined reference value, and determine whether to output a trip signal according to the comparison results.

In an embodiment, when the amplified electrical signal has value equal to or greater than a reference value, the microcomputer may generate a trip signal.

According to embodiments of the present invention, since an amplification factor is differently applied such that loss of a quantity of light with respect to an input signal is compensated for according to a length of an optical fiber cable for a point sensor. Thus, an occurrence of an arc can be more accurately detected, whereby power facilities and humans can be optimally protected from an arc accident.

Further scope of applicability of the present application will become more apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from the detailed description.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 a block diagram illustrating a configuration of a digital protection relay according to an embodiment of the present invention;
FIG. 2 is a view illustrating a signal waveform when an optical signal for sensing an arc passes through an optical fiber cable having an X length;
FIG. 3 is a view illustrating a signal waveform when an optical signal for sensing an arc passes through an optical fiber cable having a 2X length; and
FIG. 4 is a view illustrating a signal waveform when an optical signal for sensing an arc passes through an optical fiber cable having a 3X length.

### DETAILED DESCRIPTION OF THE INVENTION

Description will now be given in detail of the exemplary embodiments, with reference to the accompanying drawings. For the sake of brief description with reference to the drawings, the same or equivalent components will be provided with the same reference numbers, and description thereof will not be repeated.

Hereinafter, a digital protection relay according to an embodiment of the present invention will be described in detail with reference to the accompanying drawings. In describing the present invention, if a detailed explanation for a related known function or construction is considered to unnecessarily divert the gist of the present invention, such explanation will be omitted but would be understood by those skilled in the art. Also, similar reference numerals are used for the similar parts throughout the specification.

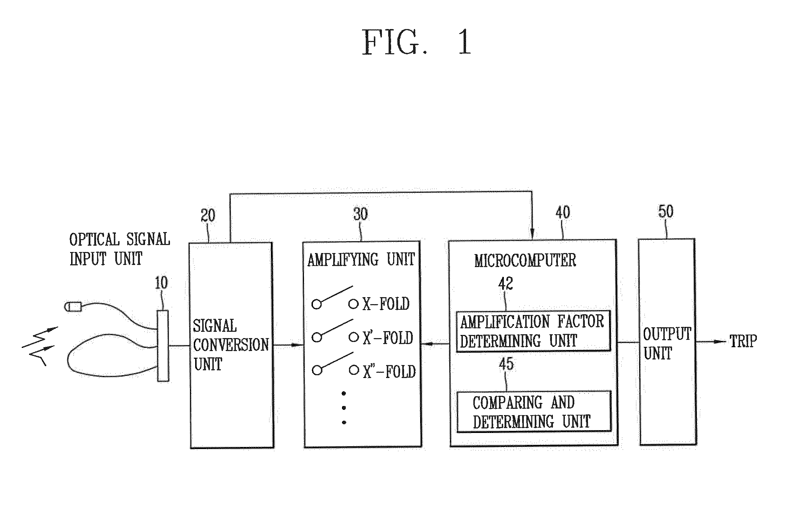

First, referring to FIG. 1, a digital protection relay according to an embodiment of the present invention may include an optical signal input unit 10, a signal conversion unit 20, an amplifying unit 30, a microcomputer 40, and an output unit 50. However, this configuration may be modified as necessary.

The optical signal input unit 10 may receive an optical signal through, for example, a point channel and/or a loop channel.

The signal conversion unit 20 may convert the optical signal into an electrical signal, and output the converted electrical signal. Also, the signal conversion unit 20 may convert an analog signal into a digital signal and output the converted digital signal to the microcomputer 40.

The amplifying unit 30 may selectively apply an amplification factor to the electrical signal on the basis of a control signal. In detail, the amplifying unit 30 differently applies an amplification factor to the converted optical signal according to a control signal output from the microcomputer 40. For example, the amplifying unit 30 may increase an amplification factor with respect to an optical signal having a high attenuation rate, and decrease an amplification factor with respect to an optical signal having a low attenuation rate. In particular, in the case of an optical fiber cable for a point sensor, as a length thereof is increased, an attenuation rate thereof is also increased. Thus, the microcomputer 40 determines an amplification factor with respect to an optical signal in consideration of a length of an optical fiber cable and a quantity of light, and transfers the determined amplification factor in the form of a control signal to the amplifying unit 30.

The amplifying unit 30 may include a plurality of operational amplifiers selectively driven on the basis of a control signal received from the microcomputer 40. Thus, the amplifying unit 30 may have an amplification factor proportional to a length of the optical fiber cable on the basis of the plurality of selectively driven operational amplifiers. The operational amplifiers may be provided by the amount required for amplifying the amplification factor one time, twice, trebly, and quadruply.

Also, the amplifying unit 30 may include one or more switching units (not shown) for selectively driving the plurality of operational amplifiers according to the amplification factor. The switching unit may be configured as a mechanical switching unit or a relay, for example. For example, in a case in which a smaller amount of operational amplifiers are used, some operational amplifiers may be commonly used, and to this end, a switching unit (not shown) may be connected to the commonly used operational amplifiers. In this case, the switching unit may be differentially turned on or off according to a control signal from the microcomputer 40.

Based on a length of an optical fiber cable, the microcomputer 40 may determine an amplification factor in proportion to the length of the optical fiber cable, and output the determined amplification factor as the control signal. Here, the optical fiber cable is a cable for transmitting an optical signal for sensing an arc, and here, the optical fiber cable refers to an optical fiber cable for a point sensor. Also, the microcomputer 40 may compare the amplified electrical signal with a predetermined reference value, and determine whether to drive the digital protection relay according to the comparison results.

Also, as illustrated in FIG. 1, the microcomputer 40 may include an amplification factor determining unit 42 and a comparing and determining unit 45. In detail, the amplification factor determining unit 42 may compare an amplification factor proportional to a length of the optical fiber cable with an amplification factor with respect to a reference length. Also, the comparing and determining unit 45 may determine whether or not an arc has occurred by comparing a magnitude of an electrical signal output from the amplifying unit 30 with a predetermined reference value. Here, the reference value refers to a minimum reference value for determining an occurrence of an arc.

In addition, the microcomputer 40 may compare the amplified optical signal from the amplifying unit 30 with a predetermined reference value to determine whether or not an arc has occurred according to the comparison results, and determine whether to output a trip signal.

When the magnitude of the electrical signal is equal to or greater than the reference value according to the comparison results of the comparing and determining unit 45 of the microcomputer 40, the output unit 50 displays value 1. Also, when the magnitude of the electrical signal is smaller than the reference value, the output unit 50 displays value 0. To this end, the output unit 50 may include a display screen configured as a liquid crystal display (LCD), a light emitting diode (LED) display, or the like.

In an embodiment, when the amplified electrical signal is equal to or greater than the reference value according to the comparison results, the microcomputer 40 may generate a trip signal. The trip signal may interrupt an input current by using a signal of a protection relay of a circuit breaker, thus protecting power facilities from an arc.

In an embodiment, when a value displayed on the output unit 50 is 1, the microcomputer 40 may determine that an arc has occurred, and output a trip signal. Meanwhile, when a value displayed on the output unit 50 is 0, the microcomputer 40 determines that an arc has not occurred, so it does not drive the digital protection relay.

In an embodiment, the amplifying unit 30 includes a plurality of operational amplifiers. The amplifying unit 30 may selectively drive the operational amplifiers according to a control signal received from the microcomputer 40, apply a corresponding amplification factor to an input signal (i.e., apply a different amplification factor to each input signal), and output the same.

Here, the microcomputer 40 may calculate a transfer rate of the optical signal that passes though the optical fiber cable through a predetermined calculation process to roughly detect a length of the optical fiber cable. In this case, however, a transfer rate of the optical signal may vary according to a type of a used cable, a transmission mode, or a signal modulation scheme, so it is based upon the premise that these are under the same conditions or the values are previously known. In this case, the microcomputer 40 may determine an amplification factor with respect to the input signal such that it is proportional to the sensed length of the optical fiber cable, and output a corresponding control signal to the amplifying unit 40.

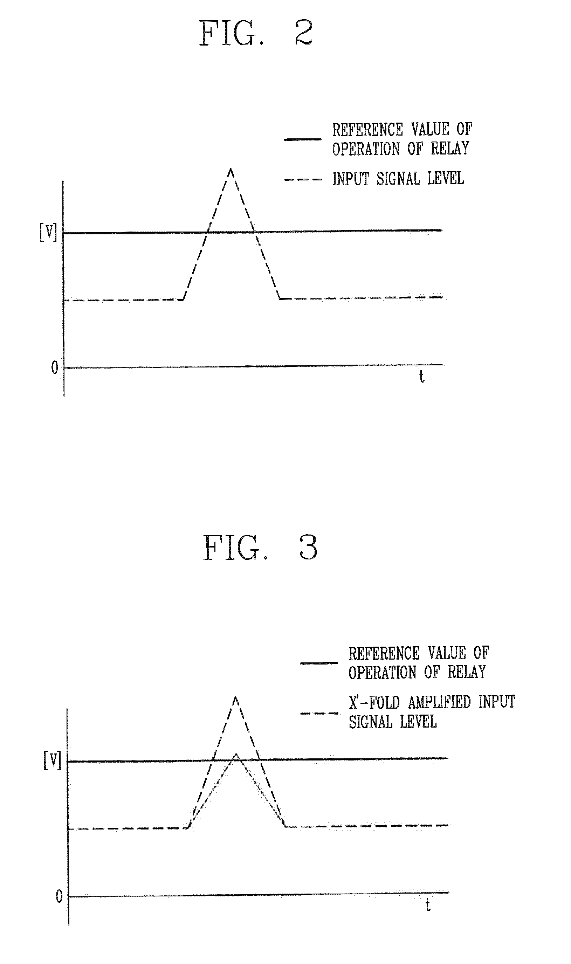

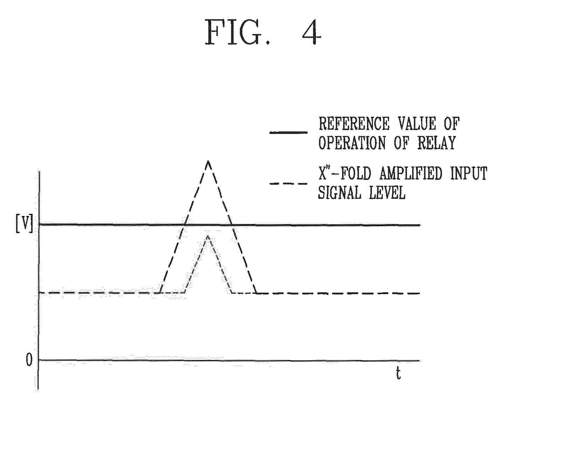

In this connection, FIGS. 2 and 4 show embodiments in which different amplification factors are applied to optical signals for sensing an arc according to a length of an optical fiber cable, in particular, an optical cable for a point sensor.

FIG. 2 is a graph showing a signal waveform when an optical signal for sensing an arc passes through an optical fiber cable having Xm and having a quantity of light of, for example, 25000 lux, according to an embodiment of the present invention. Here, it is assumed that an amplification factor in this case is X. Meanwhile, FIG. 3 is a graph showing a signal waveform when an optical signal for sensing an arc passes through an optical fiber cable having 2Xm and having a quantity of light of, for example, 25000 lux, according to an embodiment of the present invention. Here, FIG. 3 illustrates a waveform of a signal having an amplification factor amplified by approximately X'-fold with respect an input signal. Also, FIG. 4 is a graph showing a signal waveform when an optical signal for sensing an arc passes through an optical fiber cable having 3X and having a quantity of light of, for example, 25000 lux, according to an embodiment of the present invention. Here, FIG. 4 illustrates a waveform of a signal having an amplification factor amplified by approximately X"-fold with respect an input signal.

As illustrated in FIGS. 3 and 4, as the length of the optical fiber cable, in particular, the optical cable for a point sensor, is increased, loss of the quantity of light is proportionally increased to attenuate a magnitude of the signal. Thus, the signal has a magnitude of a signal level not exceeding a predetermined reference value as a reference for determining an occurrence of an arc, resultantly degrading a function of the digital protection relay. Thus, in accordance with an embodiment of the present invention, as a length of the optical fiber cable, in particular, the optical cable for a point sensor, sensed by the microcomputer 40 or any other independent device is increased, an amplification factor of an input signal is increased proportionally (i.e., in proportion to the length of the optical fiber cable) in order to compensate for loss of the quantity of light with respect to the input signal. In addition, in this manner, an occurrence of an arc can be more accurately detected, to thus optimally protect power facilities and humans from an arc accident.

Hereinafter, an operation of the digital protection relay according to an embodiment of the present invention will be described. First, an optical signal for sensing an arc is applied through a point channel and/or a loop channel. In general, the point channel and the loop channel are independently configured. The applied optical signal is converted into an electrical signal through a predetermined signal conversion unit. Then, the microcomputer determines an amplification factor with respect to the converted optical signal and output it as a control signal to the amplifying unit. In this case, the amplification factor with respect to the optical signal may vary according to a length of the optical fiber cable through which the optical signal is transmitted. Namely, as the length of the optical fiber cable is increased, an attenuation rate of a magnitude of the converted electrical signal is further increased, and thus, as the length of the optical fiber cable is increased, a signal amplification factor should be increased. For example, it is assumed that when a quantity of light of an applied optical signal is 2500 lux and a length of an optical fiber is approximately 10m, an amplification factor is X. Then, if a length of the optical fiber is 20m over the same quantity of light, the amplification factor is increased to 2X, and if a length of the optical fiber is 3m over the same quantity of light, the amplification factor is increased to 3X, thereby compensating for a signal level attenuation rate increased due to the increase in the length of the optical fiber cable. In this manner, an optical signal amplified in proportion to a length of an optical fiber cable and a predetermined reference value are compared, and when a magnitude of the amplified optical signal is greater according to the comparison results, it is determined that an arc has occurred, and a trip signal for interrupting an input current is output. In this case, it may be implemented such that when a duration in which a magnitude of the amplified optical signal is maintained to be greater than a predetermined reference value exceeds a predetermined duration, it is determined that an arc has occurred and a trip signal is output.

As described above, in the case of the digital protection relay according to an embodiment of the present invention, an amplification factor compensating for a loss of a quantity of light is applied according to a length of an optical fiber cable for a point sensor, whereby an occurrence of an arc can be more accurately detected, and thus, power facilities and human causalities can be optimally protected from an arc accident.

In addition, according to an embodiment of the present invention, a different amplification factor is applied such that a loss of a quantity of light with respect to an input signal is compensated for according to a length of an optical fiber cable for a point sensor, whereby an occurrence of an arc can be more accurately detected, and thus, power facilities and human causalities can be optimally protected from an arc accident.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A digital protection relay comprising:
an optical fiber cable, for a point sensor, configured to transmit an optical signal for sensing an arc;
a signal conversion unit 20 configured to convert the optical signal into an electrical signal, and output the converted electrical signal;
an amplifying unit 30 configured to selectively apply an amplification factor to the electrical signal on the basis of a control signal, and output the same; and
a microcomputer 40 configured to output the control signal for determining the amplification factor according to a length of the optical fiber cable, and determine whether to drive the digital protection relay according to results obtained by comparing the amplified electrical signal with a predetermined reference value.

2. The digital protection relay of claim 1, wherein the amplifying unit 30 includes a plurality of operational amplifiers and selectively drives the operational amplifiers to have an amplification factor proportional to a length of the optical fiber cable according to the control signal received from the microcomputer 40.

3. The digital protection relay of any of claims 1 to 2, wherein the microcomputer 40 comprises:
an amplification factor determining unit 42 configured to compare the amplification factor proportional to a length of the optical fiber cable with an amplification factor with respect to a predetermined reference length to determine the amplification factor; and
a comparing and determining unit 45 configured to compare a magnitude of the electrical signal output from the amplifying unit 30 with a predetermined reference value to determine whether an arc has occurred.

4. The digital protection relay of claim 3, further comprising:
an output unit 50 configured to display value '1' when the magnitude of the electrical signal is equal to or greater than the reference value according to the comparison results from the comparing and determining unit 45, and display value '0' when the magnitude of the electrical signal is smaller than the reference value,
wherein when a value displayed on the output unit 50 is 1, the microcomputer 40 may determined that an arc has occurred, and output a trip signal.
